# EUROPEAN PATENT SPECIFICATION

(11) **EP 0 820 642 B1**
(45) Date of publication and mention of the grant of the patent: **17.10.2001**
(21) Application number: 96910270.6
(22) Date of filing: 09.04.1996
(51) Int. Cl.: H01L 21/318, H01L 21/22, H01L 21/266

(54) **METHOD FOR PRODUCING A SEMICONDUCTOR DEVICE HAVING A SEMICONDUCTOR LAYER OF SiC COMPRISING A MASKING STEP**
VERFAHREN MIT EINEM MASKIERUNGSSCHRITT ZUR HERSTELLUNG EINES HALBLEITERBAUELEMENTS MIT EINER SIC HALBLEITERSCHICHT
PROCEDE COMPRENANT UNE ETAPE DE MASQUAGE POUR L'ELABORATION D'UN DISPOSITIF SEMI-CONDUCTEUR COMPORTANT UNE COUCHE SEMI-CONDUCTRICE DE SiC

(30) Priority: 10.04.1995 SE 9501312
(43) Date of publication of application: 28.01.1998
(73) Proprietor: ABB RESEARCH LTD., 8050 Zürich (CH)
(72) Inventor: HARRIS, Christopher, S-191 27 Sollentuna (SE); KONSTANTINOV, Andrei, S-581 31 Linköping (SE); JANZEN, Erik, S-590 30 Borensberg (SE)
(74) Representative: Olsson, Jan
(86) International application number: PCT/SE96/00450
(87) International publication number: WO 96/32743

(56) References cited:
- EP-A- 0 380 340
- FR-A- 2 707 425
- US-A- 4 030 942
- US-A- 4 058 413
- US-A- 5 401 686

## Description

### TECHNICAL FIELD OF THE INVENTION AND PRIOR ART

The present invention relates to a method for producing a semiconductor device according to the preamble of appended claim 1.

The production of all types of semiconductor devices is comprised, such as for example different types of diodes, transistors and thyristors.

Such devices are particularly used in applications in which it is possible to benefit from the superior properties of SiC in comparison with especially Si, namely the capability of SiC to function well under extreme conditions. SiC has a high thermal stability due to a large bandgap energy, such that devices fabricated from said material are able to operate at high temperatures, namely up to 1000 K. Furthermore, it has a high thermal conductivity, so that SiC devices can dissipate a high power without overheating. SiC also has a more than five times higher breakdown field than Si, so that it is well suited as a material in high power devices operating under conditions where high voltages may occur in the blocking state of a device.

A heat treatment in the semiconductor device production method may be for instance a heating of the SiC layer for obtaining a diffusion of dopants thereinto or an annealing after ion implantation in the SiC layer so as to activate the dopants implanted. Due to the character of SiC such a heat treatment has to be carried out at comparatively high temperatures, mostly above 1500°C, which makes it impossible to use traditional mask materials, such as SiO₂ or Si₃N₄, as used for Si, inter alia for diffusion in Si.

A possible mask material for producing semiconductor devices having a semiconductor layer of SiC would be obtained by using the so called self-masking technique, namely by employing SiC itself as a mask. In the diffusion case this will mean that the region which should be masked from diffusion would be covered with a sufficiently thick SiC layer, so that the diffusion front may not reach the device region which must be protected from diffusion. The disadvantage of the self-masking technique is the requirement of obtaining a thick masking layer on the crystal surface. In fact, the thickness of the masking layer of SiC cannot be lower than the dopant diffusion depth provided the diffusion coefficient is the same in the region where the diffusion shall be obtained and in the masking layer of SiC, so that the self-masking technique is not a real planar technique. Besides, the planar or nearly planar geometry is highly desirable from view point of device technology, because the device patterning, etching and metallization can be performed much more accurately on a flat wafer surface. Furthermore, the self-masking technique involves lapping and polishing on a flat polisher to remove the masking layer of SiC, which has been found to severely deteriorate the device performance due to mechanical damages which penetrate into the crystal bulk. In particular, dealing with the application of the diffusion technique for fabrication of diffused guard rings in SiC power devices turns out to be not practical, because of the deep dopant penetration required for these guard rings. Thickness of the masking SiC layers consequently turns out to be unreasonably high.

### SUMMARY OF THE INVENTION

The object of the present invention is to provide a method for selective doping of different portions of an SiC layer by diffusion and by using a mask over such portions that shall not be doped, which does not have the disadvantages of the materials discussed above, that may in the practice not be used for such a method, when the material is SiC.

This object is according to the invention obtained by providing a method according to independent claim 1.

By using a mask made of a material having crystalline AIN as only component or AIN as a major component of a crystalline alloy a mask having a very good lattice match with SiC is obtained, and this mask will also withstand the high temperatures necessary for diffusion of dopants in SiC. Thanks to the good lattice match of AIN and SiC the density of defects at the interface between the mask and the SiC layer will be very low, so that this mask will efficiently prevent diffusion of dopants along that interface through defects from occurring.

AIN has a very good lattice match with SiC with a misfit of only 0,7%, it has nearly the same coefficient of thermal expansion as SiC and it is stable at the high temperatures (up to 2200°C) used when heat treatment of SiC layers takes place during the production of semiconductor devices. Due to said lattice match high quality AIN layers may be grown on SiC for producing a mask, which can be patterned if desired for diffusion of dopants into the SiC layer. The good lattice match of AIN to SiC is important for preventing enhanced diffusion along the interface via defects and from the surface through defects during said heat treatment of the SiC layer. Some other compounds, like the other group 3B-nitrides and silicon carbide itself may be added in minor amounts to AIN for forming a mask of a crystalline alloy constituting said material, although such group 3B-nitrides have a considerably inferior lattice matching and a much higher decomposition rate at elevated temperatures than AIN. However, the addition of such minor amounts of said compounds to the masking material may appear to be desirable, for example from view point of the deposition process convenience and on the other hand will not deteriorate the masking properties or high temperature stability of the masking material. Another advantage of using AIN as mask material is that it has a good blocking tolerance for diffusion, especially for diffusion of boron, which probably will be the most interesting dopant to introduce into said SiC layer by diffusion due to the high diffusitivity of boron in SiC at elevated temperatures. This is explained by the fact that boron is an isoelectronic impurity in AIN, so that a reaction between boron and nitrogen results in boron nitride, a refractory compound chemically close to AIN. Intermixing of BN and AIN is very slow at any temperature below the melting point.

FR 2 707 425 only shows that it is already known to use AIN on SiC as an insulating layer, more exactly as a gate insulator, or the capability thereof to withstand high annealing temperatures (1000-2000°C), but AIN is not used as a mask against diffusion into areas coated thereby when a diffusion step is carried out into a SiC layer. AIN is here only used as an insulating layer exactly for the ability thereof to withstand high temperatures and not as a diffusion mask. No dopants are here supplied to the SiC layer during any heat treatment for diffusion of said dopants into the SiC layer, and the arrangement of the AIN-layer has nothing to do with any selective doping through diffusion, but is only made for providing a gate insulator.

US 4 058 413 shows that it is already known to use AIN as a "protective overcoat" onto GaAs so as to prevent Ga and As from diffusing outwardly into this "protective overcoat" during annealing after ion implantation of N-type dopants into Ga and As. Thus, AIN does not constitute any protection against diffusion of dopants. The task thereof is not to prevent diffusion into GaAs but quite contrary of Ga and As, which are not dopants, out of the semiconductor layer, i.e. in fact dissociation thereof. The temperature is about 900°C. This document is not occupied with SiC and no lattice match of the semiconductor material and AIN takes place so as to prevent diffusion as a consequence of interface defects.

Thus, the use of a mask according to the invention makes it possible to form guard rings for smoothing out the electric field in the peripheral region in the blocking state of a power device having a SiC layer, so that the electric field at the periphery can remain well below the breakdown threshold. This kind of use of the guard ring technique for device termination has not been used for silicon power devices, because they are so thick that it is technically difficult to diffuse the dopants deep enough. However, silicon carbide power devices have a considerably lower base thickness due to the high breakdown fields of SiC, and the guard ring technique may therefor be suitable for such power devices.

According to another preferred embodiment of the invention said method comprises a step used in conjugation with ion implantation in a portion of said SiC layer not coated by said mask, said step being carried out before said heat treatment is carried out, and said heat treatment constitutes an annealing for recrystallizing the ion-implanted layer of the SiC layer, said mask preventing impurity diffusion into areas covered thereby from occurring. Such annealing will take place at high temperatures, well above 1500°C, and the mask according to the invention will efficiently prevent impurity diffusion into areas covered thereby from occurring because of the possibility to grow high quality AIN layers on SiC and the stability and the blocking tolerance for diffusion of AIN.

According to a further preferred embodiment of the invention said method according to the two embodiments lastly described comprises a step of ion implantation in said peripheral region of the SiC layer, in which ions of the same type, P or N, as the dopants to be diffused into the SiC layer are implanted while creating a thin highly doped layer close to the surface of the SiC layer and then first an annealing heat treatment and then a heat treatment combined with a supply of dopants for guard ring formation is carried out, the diffusion for said guard ring formation being enhanced by the existence of said highly doped thin layer. This means that the method including the application of a mask according to the invention will make it possible to create guard rings for SiC power devices while using the ability thereof to function as a mask for annealing heat treatment as well as diffusion heat treatment.

It is obvious that the production steps mentioned in the claims are only some of a great number of production steps well established within the technique of semiconductor device fabrication, such as the application of ohmic contacts, patterning or removal of the mask by for instance reactive ion etching and so on. Thus, "the application of a mask on at least a portion of said SiC layer" does not normally mean that the mask in one step is applied on a portion of the SiC layer, but the mask may be first applied onto the entire SiC layer and then removed by a suitable technique from parts of the SiC layer leaving it on said portion.

Further advantages and preferred features of the invention will appear from the following description and the other claims.

### BRIEF DESCRIPTION OF THE DRAWING

With reference to the appended drawing, below follows a specific description of a preferred embodiment of the invention cited as an example.

In the drawing:

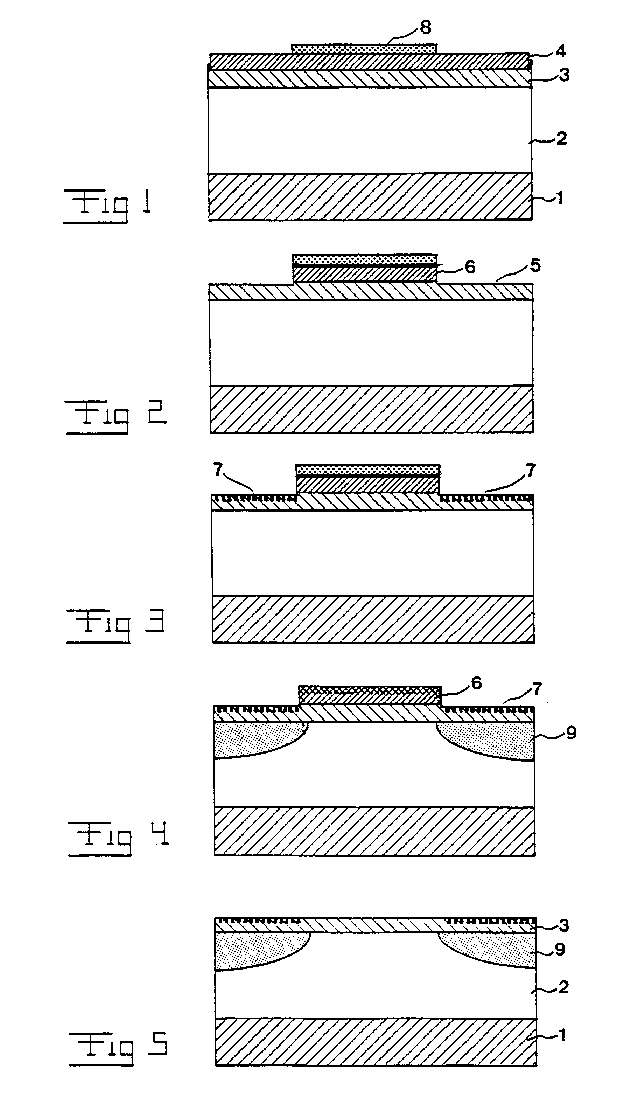

Figs 1-5 illustrate schematically different steps of a method for producing a semiconductor power device in the form of a rectifier diode of SiC according to a preferred embodiment of the invention.

### DETAILED DESCRIPTION OF A PREFERRED EMBODIMENT OF THE INVENTION

Figs 1-5 illustrate a few important steps of a large number of steps of a method according to the invention for producing a power diode made of SiC by using a planar-diffusion technology. All the layers of the this device are made of SiC, but hetero-junction devices are also within the scope of the invention. The device will have three differently doped layers, namely a third highly doped layer 1 of N-type for making a low resistance contact with an ohmic contact metal plate of the device not shown in the figures, a second low-doped N-type thicker layer 2 arranged thereon and a first thinner P-type layer 3 arranged on the top of the second layer 2 and forming a pn-junction at the interface therewith. In a rectifier diode having these three layers the space charge region is primarily provided by said second low-doped layer, which will take the main part of the voltage applied on the device in the reverse operating direction thereof, and such a device may have a breakdown voltage in the kV-range. However, the breakdown voltage will be lower in the peripheral region of the device than in the bulk thereof due to electric field concentraion, surface defects and the risks of spark formation and the like, so that different passivation techniques are necessary. A serious problem with the peripheral breakdown is due to its localized nature, since it only occurs at a single point at the periphery and therefore results in a very high current density and specific power dissipation. This may lead to an irreversible device degradation even in the case of a rather low reverse current. Accordingly, it would be better if the possible breakdown would occur uniformly over the diode area, so that the current density will be very low and the flow of a high reverse current would not deteriorate the device parameters. Thus, it is highly desirable to remove the weak spots of the diode, since this would not only increase the operation voltage but also make it unnecessary to provide a circuitry for preventing the rectifier from overloading. Accordingly, it is preferred that a possible breakdown should occur first in the bulk instead of near the periphery.

The method for producing a semiconductor device to be described now attends to this problem. The method comprising the step of deposition of a crystalline AIN layer 4 on the top of the P-type SiC sub-layer 3. It will be possible to epitaxially grow such a crystalline AIN layer with a very high quality on the SiC layer, since the lattice match of crystalline AIN and crystalline SiC is very good, which will also result in a very high quality at the interface between the layers 3 and 4 with a very low concentration of defects.

A removal of the AIN layer 4 in the selected areas to be doped is then carried out by reactive ion etching (RIE) in the peripheral regions 5 as shown in Fig 2. It is thereby important that a portion of the P-type first layer 3 is retained in these peripheral regions 5. Accordingly, a patterned mask 6 is now obtained.

In the next step a p-type layer 7 heavily doped with aluminium is applied on the top of the regions subject to boron diffusion (discussed below) to enhance boron penetration. Such a layer is prepared, for example, by Al ion implantation with an energy of 50-100 KeV and a dose of 2-3 10¹⁶ cm⁻³ which gives a layer thickness in the region of 0.05-0.2 µm. The layer is initially amorphized as implanted, however the high temperature treatment in course of boron diffusion results in its recrystallization. An amount of Al diffusion into the crystal actually happens to occur however the diffusivity of Al in SiC is very low and the main effect of the Al-doped layer is the enhancement of boron diffusion. It is clear that a thin layer heavily doped with Al can as well be prepared by other techniques for example by epitaxial growth, however the ion implantation in this case seems to provide the easiest solution from the viewpoint of technical complexity.

In the next step boron is supplied to the surface of the SiC layer while heating the SiC layer at 1600-1750°C. It has been found that boron has a reasonably high diffusivity in SiC at these temperatures, and the thin highly doped P-type layer 7 will enhance the diffusion of boron in the peripheral regions 5 of the SiC layer, whereas the AIN layer will efficiently block diffusion of boron thereinto and accordingly into the central active region of the semiconductor layers 2 and 3. Thus, a suitable choice of the diffusion regimes (temperature, diffusion time, supply rate of boron) will provide a sufficiently thick compensated layer 9 in the form of a guard ring in the peripheral region of the wafer and the penetration of boron through the mask 6 will be prevented. The guard rings thus obtained will extend the pn-junction of the device thus created in the peripheral regions thereof, so that the electric field in the peripheral region will be smoothed out in a blocking state of such a power device, preventing a possible breakdown from occurring firstly at the periphery of the device.

Finally, it is shown in Fig 5 how the structure has been etched by RIE for removing the AIN layer 4 from the active region and to define the diode area. Then several steps of the usual sequence of device termination follows, such as oxidation or deposition of a dielectric, contact metal deposition and so on. The real method for producing the power rectifier diode will of course involve numerous additional steps, which may be performed in a conventional way, and only the steps of importance for the invention have been described above.

In another preferred embodiment the boron dopant is introduced into SiC by ion implantation before the heat treatment stage. The regions in which boron penetration is undesired can be protected by AIN and by an additional metal mask which is removed after the implantation.

However, annealing away the implantation induced structural disorder requires nearly same as high temperatures as diffusion in case of p-type dopants in SiC and a considerable dopant diffusion happens to occur. This inevitably brings in contamination of the regions where acceptor penetration must be avoided, for example of the central active area of a power rectifier diode, unless those regions are appropirately masked during the heat treatment. It is clear, that in the present embodiment the AIN mask works quite similarly as in case of conventional thermal diffusion protects from boron diffusion during the annealing stage. Apart from the boron implantation stage and that the Al implantation is left out all the steps are the same as considered in the first embodiment. Boron may be not added to the load of the diffusion crucible, however it may be as well added to suppress its outdiffusion during the heat treatment.

The invention is of course not in any way restricted to the embodiment described above, but several possibilities to modifications thereof would be apparent to a man skilled in the art without departing from the basic idea of the invention as defined in the claims.

The method may be used for the production of any type of semiconductor device having a SiC layer. The definition "SiC layer" will also include that this SiC layer may consist of several sub-layers as shown in the Figures.

Although the first and second portion is defined as being singulars in the claims, each of these portions may comprise several separated sub-portions.

All definitions concerning the material of the different layers of course also include inevitable impurities as well as intentional doping when SiC is concerned.

Boron has been found to be most suitable as dopant for defining the guard rings, but diffusion of other dopants may be envisaged, such as for instance beryllium, which has a reasonably high diffusivity in SiC but is highly toxic.

## Claims

1. A method for producing a semiconductor device having a semiconductor layer of SiC (1-3), said method comprising at least the steps of a) application of a mask layer (4) on at least a portion of said SiC layer and b) a heat treatment of said SiC layer, said heat treatment being carried out above 1500°C, wherein said mask layer is made of a material having crystalline AIN as only component or AIN as a major component of a crystalline alloy constituting said material and wherein said mask layer (4) is applied on said layer portion before said heat treatment, **characterised in that** a patterned diffusion mask (6) is formed in step a) and a possible following step to only coat a first portion of said SiC layer leaving a second portion (5) thereof uncoated, and that dopants are supplied to the SiC layer during said heat treatment for diffusion of said dopants into the SiC layer at said second portion thereof for doping the SiC layer there.

2. A method according to claim 1, **characterized in that** said mask layer (4) is made of crystalline AIN.

3. A method according to claim 1, **characterized in that** said mask layer (4) is made of a material having AIN as a major component of a crystalline alloy, which further comprises one or a combination of group 3B-nitrides and SiC.

4. A method according to claim 1, **characterized in that** boron is the dopant supplied for said diffusion.

5. A method according to any of the preceding claims for producing a semiconductor power device, **characterized in that** the peripheral regions (5) of the SiC layer are left uncoated by said diffusion mask (6) for obtaining diffusion of dopants at the periphery thereof, and that the heat treatment and thereby the diffusion is carried out under such conditions that the dopants may penetrate through a junction creating the space charge region of said device for creating a guard ring (9) arranged to smoothe out the electric field in the peripheral region in a blocking state of the power device so created.

6. A method according to claim 5, **characterized in that** said SiC layer is made of at least two sub-layers, namely a first uppermost layer (3) of P-type and a second layer (2) of N-type onto which the first layer is arranged.

7. A method according to any of the preceding claims, **characterized in that** a step of ion implantation is carried out in a portion (5) of said SiC layer (1-3) not coated by said diffusion mask (6) before said heat treatment is carried out, and that said heat treatment constitutes an annealing for re-crystallizing the ion-implanted layer of the SiC layer, said diffusion mask (6) preventing impurity diffusion into areas covered thereby from occurring.

8. A method according to any of the preceding claims, **characterized in that** it comprises at least the following steps carried out in the following order: 1) deposition of the mask material on the entire surface of the SiC layer, 2) patterning the mask for producing an uncoated second portion of the SiC layer, 3) heat treatment of the SiC layer and 4) removal of the mask in a non-mechanical way.

9. A method according to claim 5 and 7, **characterized in that** said ion implantation is carried out in said peripheral region (5) of the SiC layer, that ions of the same type, P or N, as the dopants to be diffused into the SiC layer are implanted while creating a thin highly doped layer (7) close to the surface of the SiC layer and then first an annealing heat treatment and then a heat treatment combined with a supply of dopants for guard ring formation is carried out, the diffusion for said guard ring formation being enhanced by the existence of said highly doped thin layer.

## Patentansprüche

1. Verfahren zur Herstellung eines Halbleiterbauelementes mit einer Halbleiterschicht aus SiC (1-3) mit zumindest den Schritten a) Aufbringen einer Maskierungsschicht (4) auf zumindest einem Teilbereich der SiC-Schicht und b) einer Wärmebehandlung der SiC-Schicht, welche bei über 1500°C durchgeführt wird, wobei die Maskierungsschicht aus einem Material gebildet ist, das kristallines AlN als einzigen Bestandteil oder das AlN als einen Hauptbestandteil einer kristallinen Legierung aufweist, die das Material bildet, und wobei die Maskierungsschicht (4) vor der Wärmebehandlung auf dem Schichtteilbereich aufgebracht wird, **dadurch gekennzeichnet, daß** eine strukturierte Diffusionsmaske (6) in Schritt a) gebildet wird und ein möglicher nachfolgender Schritt nur zur Beschichtung eines ersten Teilbereichs der SiC-Schicht, von der ein zweiter Teilbereich (5) unbeschichtet bleibt, und daß der SiC-Schicht während der Wärmebehandlung Dotierstoffe zugeführt werden, damit die Dotierstoffe in dem zweiten Teilbereich der SiC-Schicht in diese eindiffundieren und die SiC-Schicht dort dotieren.

2. Verfahren nach Anspruch 1, **dadurch gekennzeichnet, daß** die Maskierungsschicht (4) aus kristallinem AlN gebildet wird.

3. Verfahren nach Anspruch 1, **dadurch gekennzeichnet, daß** die Maskierungsschicht (4) aus einem Material gebildet wird, das AlN als einen Hauptbestandteil einer kristallinen Legierung aufweist, die ferner ein oder eine Kombination von Gruppe 3B-Nitriden und SiC umfaßt.

4. Verfahren nach Anspruch 1, **dadurch gekennzeichnet, daß** Bor als Dotierstoff für die Diffusion zugeführt wird.

5. Verfahren nach einem der vorherigen Ansprüche zur Herstellung eines Halbleiter-Leistungsbauelementes, **dadurch gekennzeichnet, daß** die peripheren Bereiche (5) der SiC-Schicht durch die Diffusionsmaske (6) unbeschichtet bleiben, damit eine Diffusion der Dotierstoffe an der Peripherie der SiC-Schicht erreicht wird, und daß die Wärmebehandlung und dadurch die Diffusion unter derartigen Bedingungen durchgeführt wird, daß die Dotierstoffe durch einen Übergang dringen können, der den Raumladungsbereich des Bauelementes bildet, um einen Schutzring (9) zu erzeugen, der so angeordnet ist, daß in einem Sperrzustand des so erzeugten Leistungsbauelementes das elektrische Feld im peripheren Bereich geglättet wird.

6. Verfahren nach Anspruch 5, **dadurch gekennzeichnet, daß** die SiC-Schicht aus zumindest zwei Unterschichten gebildet wird, nämlich eine erste oberste Schicht (3) vom P-Typ und eine zweite Schicht (2) vom N-Typ, auf der die erste Schicht angeordnet wird.

7. Verfahren nach einem der vorherigen Ansprüche, **dadurch gekennzeichnet, daß**, bevor die Wärmebehandlung durchgeführt wird, in einem Teilbereich (5) der SiC-Schicht (1-3), der nicht durch die Diffusionsmaske (6) beschichtet wurde, ein Ionenimplantationsschritt durchgeführt wird, und daß die Wärmebehandlung ein Ausheilen zur Rekristallisation der ionenimplantierten Schicht der SiC-Schicht darstellt, wobei die Diffusionsmaske (6) verhindert, daß eine Verunreinigungsdiffusion in die durch die Diffusionsmaske (6) bedeckten Bereiche auftritt.

8. Verfahren nach einem der vorherigen Ansprüche, **dadurch gekennzeichnet, daß** es zumindest die folgenden Schritte umfaßt, die in der folgenden Reihenfolge ausgeführt werden: 1) Abscheidung des Maskenmaterials auf der gesamten Oberfläche der SiC-Schicht, 2) Strukturieren der Maske zur Erzeugung eines unbeschichteten zweiten Teilbereiches der SiC-Schicht, 3) Wärmebehandlung der SiC-Schicht und 4) Entfernen der Maske auf nicht-mechanische Weise.

9. Verfahren nach Anspruch 5 und 7, **dadurch gekennzeichnet, daß** die Ionenimplantation in dem peripheren Bereich (5) der SiC-Schicht durchgeführt wird, daß Ionen desselben Typs, P oder N, wie die in die SiC-Schicht zu diffundierenden Dotierstoffe implantiert werden, während eine dünne hochdotierte Schicht (7) nahe an der Oberfläche der SiC-Schicht erzeugt wird, und dann zuerst eine Wärmebehandlung zum Ausheilen und dann eine Wärmebehandlung verbunden mit einer Zuführung von Dotierstoffen zur Bildung des Schutzrings durchgeführt wird, wobei die Diffusion zur Bildung des Schutzrings durch die Existenz der hochdotierten dünnen Schicht verstärkt wird.

## Revendications

1. Procédé pour produire un dispositif à semiconducteur ayant une couche à semiconducteur en SiC (1 à 3), le procédé comportant au moins les étapes qui consistent à a) appliquer une couche (4) de masque sur au moins une partie de la couche en SiC et b) traiter thermiquement la couche en SiC, le traitement thermique étant effectué à une température supérieure à 1500°C, la couche de masque étant réalisée en un matériau ayant du AIN cristallin en tant que seul composant ou du AIN en tant qu'un constituant principal d'un alliage cristallin constituant le matériau et dans lequel la couche (4) de masque est appliquée sur ladite partie de couche avant le traitement thermique, **caractérisé en ce qu'**un masque (6) de diffusion configurée est formé à l'étape a) et une étape possible suivante pour uniquement recouvrir une première partie de la couche en SiC en laissant une seconde partie (5) de celle-ci non couverte, et **en ce que** des dopants sont envoyés à la couche de SiC pendant le traitement thermique pour une diffusion des dopants dans la couche en SiC dans sa seconde partie pour y doper la couche en SiC.

2. Procédé suivant la revendication 1, **caractérisé en ce que** la couche (4) de masque est en AIN cristallin.

3. Procédé suivant la revendication 1, **caractérisé en ce que** la couche (4) de masque est en un matériau ayant AIN en tant que constituant principal d'un alliage cristallin, qui comporte en outre un nitrure du groupe 3B, du SiC ou une combinaison de ceux-ci.

4. Procédé suivant la revendication 1, **caractérisé en ce que** le bore est le dopant fourni pour la diffusion.

5. Procédé suivant l'une quelconque des revendications précédentes, pour produire un dispositif de puissance à semiconducteur, **caractérisé en ce que** la région (5) périphérique et la couche SiC sont laissées non couvertes par le masque (6) de diffusion pour obtenir une diffusion de dopants à leur périphérie, et **en ce que** le traitement thermique et la diffusion qui a lieu sont effectués dans des conditions telles que les dopants peuvent pénétrer par une jonction créant la région de charge d'espace du dispositif pour créer une bague (9) de garde disposée pour lisser le champ électrique dans la région périphérique dans un état de blocage du dispositif de puissance ainsi créé.

6. Procédé suivant la revendication 5, **caractérisé en ce que** la couche en SiC est réalisée en au moins deux sous-couches, à savoir une première couche (3) la plus supérieure de type P et une seconde couche (2) de type N sur laquelle est disposée la première couche.

7. Procédé suivant l'une quelconque des revendications précédentes, **caractérisé en ce qu'**une étape d'implantation ionique est effectuée dans une partie (5) de la couche (1 à 3) en SiC qui n'est pas recouverte par le masque (6) de diffusion avant le traitement thermique, et **en ce que** le traitement thermique constitue un recuit pour la recristallisation de la couche implantée ioniquement de la couche en SiC, le masque (6) de diffusion empêchant la diffusion d'impuretés dans des zones recouvertes.

8. Procédé suivant l'une quelconque des revendications précédentes, **caractérisé en ce qu'**il comporte au moins les étapes suivantes effectuées dans l'ordre suivant : 1) dépôt du matériau de masque sur toute la surface de la couche en SiC, 2) configuration du masque pour produire une seconde partie non recouverte de la couche en SiC, 3) traitement thermique de la couche en SiC et 4) élimination du masque d'une manière non mécanique.

9. Procédé suivant les revendications 5 et 7, **caractérisé en ce que** l'implantation ionique est effectuée dans la région (5) périphérique de la couche en SiC, **en ce que** des ions du même type, P ou N, en tant que dopants à diffuser dans la couche en SiC sont implantés tout en créant une couche (7) mince fortement dopée à proximité de la surface de la couche en SiC et ensuite d'abord un traitement thermique de recuit et ensuite un traitement thermique combiné avec une fourniture de dopants pour la formation de bagues de garde sont mis en oeuvre, la diffusion pour la formation de bagues de garde étant améliorée par l'existence de la couche mince fortement dopée.
